# EUROPÄISCHE PATENTSCHRIFT

(11) **EP 3 012 173 B1**
(45) Veröffentlichungstag und Bekanntmachung des Hinweises auf die Patenterteilung: **19.07.2017**
(21) Anmeldenummer: 14189906.2
(22) Anmeldetag: 22.10.2014
(51) Int. Cl.: H05B 37/02, B61L 3/12, B61L 27/00, B61L 5/18, G01R 19/00

(54) **Verfahren zur Ermittlung eines von einem Stellwerk ausgegebenen Signalbegriffs**
Method for determining a signal aspect issued by a signal box
Procédé de détermination d'un concept de signal émis par une unité de commande

(43) Veröffentlichungstag der Anmeldung: 27.04.2016
(73) Patentinhaber: Siemens Schweiz AG, 8047 Zürich (CH)
(72) Erfinder: Baumann, Rene, 8424 Embrach (CH)
(74) Vertreter: Maier, Daniel Oliver

(56) Entgegenhaltungen:
- WO-A1-2006/056510
- WO-A1-2010/102898
- LJUNGGREN B ET AL: "MiniLEU S11 - Eine neue Generation von LEUs für ETCS", SIGNAL + DRAHT, TELZLAFF VERLAG GMBH. DARMSTADT, DE, Bd. 11, Nr. 102, 1. November 2010 (2010-11-01), Seiten 13-15, XP001557787, ISSN: 0037-4997

## Beschreibung

Die vorliegende Erfindung bezieht sich auf ein Verfahren zur Ermittlung eines von einem Stellwerk ausgegebenen Signalbegriffs.

Auf dem Gebiet des schienengebundenen Verkehrs werden moderne Zugsicherungssysteme eingesetzt, mit denen zentral erstellte Daten zur Steuerung des Zugverkehrs an dezentrale Einheiten übertragen werden respektive von diesen dezentralen Einheiten angefordert und zentral verarbeitet werden. Typische Einheiten für die zentrale Datenerstellung und -anforderung sind Stellwerke und Leitstellen. Für die dezentralen Einheiten können beispielhaft gleisseitig angeordnete Kontrolleinheiten, wie Einrichtungen zur Signal- und Weichensteuerung/-überwachung, Einrichtungen zur Steuerung und Überwachung von Gleisfreimeldeeinrichtungen, Balisen, Linienleitern und Loop-Kabeln genannt werden. Selbst die modernen Zugsicherungssysteme sind jedoch auch heute noch aufgrund der nationalen Aufstellung der Bahnunternehmungen, wie Schweizerische Bundesbahnen SBB, Österreichische Bundesbahnen ÖBB, Deutsche Bahn DB, nationale Zugsicherungssysteme, die beim Übertritt von Land zu Land fahrzeugseitig gewechselt werden müssen, was auf den Fahrzeugen einen erheblichen Aufwand hinsichtlich des Einsatzes im grenzüberschreitenden Verkehr bedeutet.

Aus diesem Grunde hat beispielsweise die Europäische Union beschlossen, ein europaweit einheitliches Zugsicherungssystem einzuführen, das unter dem Namen ETCS (European Train Control System) in der Fachwelt bekannt ist. Dieses Zugsicherungssystem verfügt über drei verschiedene Ausführungslevel, die sich in der Art der Kommunikation von Schienenfahrzeug und Leitstelle und der Ortung von Zügen unterscheiden. Im ETCS Level 1 werden die zuglenkenden Informationen von Transparentdaten- und Fixdaten-Balisen und/oder Linienleitern und/oder Loop-Kabeln drahtlos auf den Führerstand des Schienenfahrzeug übertragen und beinhalten u.a. Anweisungen zur Geschwindigkeitssteuerung und Überwachung des Zuges. Im Level 2 werden die zuglenkenden Informationen über ein Mobilfunknetz aus sogenannten Radio Block Centern auf den Führerstand übertragen und im Level 3 kommt dann noch die Integritätsprüfung sowie Eigenortung des Zuges mittels Navigationssystem, wie GPS oder Galilei (aktuell im Aufbau), zum Einsatz.

Besonders die Umrüstung der Bahnstrecken hinsichtlich der Balisen stellt für die Bahnunternehmen einen erheblichen Investitionsaufwand in ihre Infrastruktur dar. Im Rahmen dieser Umsetzung von ETCS-Projekten werden daher vermehrt Migrationsprojekt bei den europäischen Bahnbetrieben durchgeführt. Zudem versuchen die Bahnbetriebe im Rahmen dieser Migrationsprojekte hinsichtlich der Installation und des Unterhalts vermehrt vereinfachte dezentrale Strukturen zu schaffen. Dieser Ansatz schliesst beispielsweise auch die Installation von dezentralen elektronischen Steuerungseinheiten (LEU = Lineside Electronic Unit) ein, die energieautark betrieben werden können. Auf diese Weise kann ein Signalpunkt von einem nationalen proprietären Zugsicherungssystem auf ETCS Level 1 umgerüstet werden, ohne dass eine elektrische Stromversorgung für die dezentrale elektronische Steuerungseinheit zu verlegen wäre.

Ein begleitendes Ziel dieser Migrationsprojekte besteht daher auch darin, auf der bestehenden Infrastruktur aufzusetzen und nur solche Neubaumassnahmen zu treffen, die zur Erreichung des Migrationsziels unbedingt erforderlich sind. Zur Anschaltung der Altsystems an ETCS werden daher derzeit Überlegungen gemacht. Alle Hardware-seitigen Lösungen sind mit einem hohen Aufwand und Kosten verbunden, z.B. für die Erstellung von Doppelkontakten, Herbeiführung von elektrischer Energie und allgemeiner Verdrahtungsaufwand. Eine besondere Komplexität liegt daher auch noch in der Abwesenheit von elektrischen Speiseeinrichtungen in der Nähe von Signalkreisen, sodass besonders bei der Verwendung von weitgehend energieautarken Mini-LEU's zur Steuerung einer ETCS-Balise sehr energiesparende Konzepte zum Tragen kommen müssen. Hierzu sind beispielsweise Energiemanagementprozesse implementiert, die eine Mini-LEU erst mit der Annäherung eines Schienenfahrzeug mit Hilfe des von der Zugspitze abgestrahlten Telepowering-Signal aus einem Schlafmodus in einen Aktivmoduls schalten. Einmal in den Aktivmoduls geschaltet, tastet eine entsprechende in der Mini-LEU verbaute Elektronikschaltung den Signalstrom ab, um ermitteln zu können, auf welchem der Signalstromkreise ein Signalstrom (Lampenstrom) fliesst und die Signallampe daher leuchtet. Diese Abtastung erfolgt infolge des Wechselstromcharakters des Lampenstroms, der oft auch gleichgerichtet und im Zuge der Nachtabsenkung der Leuchtstärke der Signallampen auch phasenangeschnitten ist, mit der doppelten Frequenz der Frequenz des Lampenstroms, was diese Abtastung vergleichsweise energieintensiv macht. Die Druckschrift WO 2006 056 510 A1 zeigt eine Schaltung zur Ansteuerung und Überwachung einer Mehrzahl von Signallampen.

Der vorliegenden Erfindung liegt daher die Aufgabe zugrunde, ein Verfahren zur Ermittlung eines von einem Stellwerk ausgegebenen Signalbegriffs durch eine LEU anzugeben, das besonders auch den Abtastvorgang des Signalstroms im Lampenstromkreis besonders energiesparend ausführt. Diese Aufgabe wird erfindungsgemäss durch ein Verfahren zur Ermittlung eines von einem Stellwerk ausgegebenen Signalbegriffs, der mittels einer gleisseitig angeordneten punktförmigen Datenübertragungseinrichtung auf ein Schienenfahrzeug übertragbar ist, gelöst, wobei:
a) der Signalbegriff für eine Anzahl von Signallampen ausgegeben wird und in Form von je einem Signalstrom bekannter Frequenz pro Lampenstromkreis in jedem der für die Darstellung des Signalbegriffs erforderlichen Lampenstromkreise bereitgestellt wird;
b) die punktförmige Datenübertragungseinrichtung von einer gleisseitig angeordneten elektronischen Steuerungseinheit betrieben wird; und
c) der Signalstrom in jedem der Lampenstromkreise von der elektronischen Steuereinheit mittels eines Abtastbursts mit einer Anzahl von Abtastungen abgetastet wird, wobei der zeitliche Abstand zweier aufeinanderfolgender Abtastungen innerhalb eines Abtastbursts einem vorgebbaren Bruchteil der Periodendauer des Signalstroms entspricht, wobei der Bruchteil der Periodendauer ein Viertel der Periodendauer des Signalstroms beträgt.

Auf diese Weise ist es möglich, den in den Signalstromkreisen anliegenden Signalbegriff mit geringem zusätzlichen Installationsaufwand mittels der elektronischen Steuereinheit (LEU) zu ermitteln und ein diesem Signalbegriff entsprechendes Telegramm zur Aussendung mittels der punktförmigen Datenübertragungseinheit aufzubereiten. Dieses Verfahren zeichnet sich zudem durch seine Robustheit und seinen geringen Energieverbrauch aus, sodass auch eine autark betriebene elektronischen Steuereinheit mit der ihr zur Verfügung stehenden elektrischen Energie diese Aufgabe wahrnehmen kann. Durch die Festlegung des Bruchteils der Periodendauer auf ein Viertel der Periodendauer des Signalstroms kann die Detektion des Signalstroms auch dann zuverlässig erfolgen, wenn der erste Abtastzeitpunkt des Abtastburst zufällig genau in einen Nulldurchgang des Signalstroms fallen sollte.

Vorteilhafterweise kann in dem erfindungsgemässen Verfahren der Signalstrom als Wechselstrom oder als gleichgerichteter Wechselstrom ausgeführt sein. Weiter kann die punktförmige Datenübertragungseinheit als ETCS-Transparentdaten-Balise ausgestaltet sein.

Bezüglich des gewünschten sparsamen Umgangs mit der zur Abtastung erforderlichen Energie kann es vorgesehen sein, dass ein Abtastburst zwei bis fünf Abtastungen umfasst.

Weitere vorteilhafte Ausgestaltungen der Erfindung können den übrigen Unteransprüchen entnommen werden.

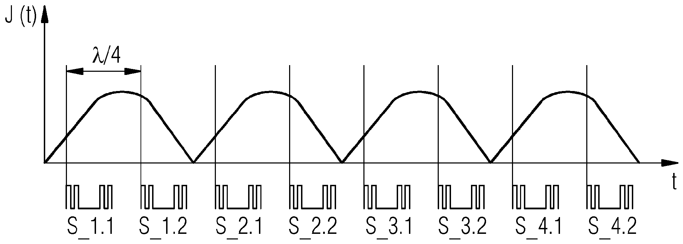

Die Erfindung wird nachfolgend anhand der Zeichnung beispielsweise näher erläutert. Dabei zeigt die Figur die Abtastung eines gleichgerichteten Signalstroms.

Im Eisenbahnverkehr bestehen die Signale üblicherweise aus einer Anzahl von Signallampen. Bei einfacheren Signalen auf der Strecke können nur eine oder zwei Signallampen pro Streckenpunkt vorgesehen sein. Bei Vorsignalen und im Bahnhofsbereich angeordneter Signal können aber auch mehr als zwei Signallampen pro Signaltafel vorgesehen sein, die entsprechend einem vom Stellwerk ausgegebenen Signalbegriff angesteuert werden. Weit verbreitet ist es hierzu noch, dass der Signalstrom für einen Lampenstromkreis vom Stellwerk als Wechselstrom oder gleichgerichteter Wechselstrom bekannter Frequenz (z.B. 40 V, 50 Hz) bereitgestellt wird und das Fliessen des Lampenstroms in den zur Anzeige des Signalbegriffs erforderlichen Lampenstromkreisen auch vom Stellwerk überwacht wird. Grundsätzlich kann der Signalstrom aber auch unabhängig vom Stellwerk bereitgestellt und das Fliessen des Signalstroms an das Stellwerk rapportiert werden.

Wird nun an diesem Streckenpunkt eine durch eine elektronische Steuerungseinheit (LEU, Mini-LEU) gesteuerte Balise installiert, die den an diesem Streckenpunkt anliegenden Signalbegriff mittels eines den Signalbegriff repräsentierenden Telegramms auf das die Balise überfahrende Schienenfahrzeug überträgt, ist es erforderlich den Signalbegriff durch die elektronische Steuereinheit zu erfassen. Hierzu wird der Signalstrom in jedem der Lampenstromkreise von der elektronischen Steuereinheit mittels eines Abtastbursts mit einer Anzahl von Abtastungen abgetastet, wobei der zeitliche Abstand zweier aufeinanderfolgender Abtastungen innerhalb eines Abtastbursts einem vorgebbaren Bruchteil der Periodendauer des Signalstroms entspricht. Das die Abtastung repräsentierende Schema ist in der Figur gezeigt. Die beiden Abtastungen eines ,Burst` sind mit x.1 und x.2 bezeichnet; S_1.1 ist die erste Abtastung des ersten Bursts, S_1.2 entsprechend die zweite Abtastung dieses Bursts. S_2.1 und S_2.2 stellen die beiden Abtastungen des zweite Bursts dar. Der rechteckige Verlauf soll die digitalisierten Werte darstellen, die Verbindung zu den Sensoren ist als Zweidrahtleitung realisiert. Deshalb wird hier auch eine detaillierte Notation für die Abtastungen angegeben, da es bei einem Übertragungsfehler auch noch ein S_1.3 geben könnte. Somit ist die bekannte Frequenz der Signalstroms in die Abtastung mit einbezogen worden, was es in dem vorliegenden Ausführungsbeispiel erlaubt, die Abtastbursts mit nur je zwei Abtastungen auszuführen. Durch die Verschiebung zweier nachfolgender Abtastungen desselben Abtastburst um ein Viertel der Periodendauer kann innerhalb eines Abtastbursts festgestellt werden, ob ein Signalstrom fliesst oder nicht. Aufgrund der zeitlichen Verschiebung von einem Viertel der Periodendauer ist die Detektion des Signalstroms auch dann möglich, wenn einer der beiden Abtastungen des Abtastbursts zufällig auf einen Nulldurchgang des Signalstroms fallen sollte. Die jeweils andere Abtastung des Abtastburst wird dann in jedem Fall den Signalstrom detektieren. Es kann mathematisch gezeigt werden, dass bei einem Viertel der Periodendauer die Summe der beiden Abtastungen immer grösser oder gleich dem Stromwert ist. Wenn dieses Verhältnis zu stark geändert wird, stimmt diese Beziehung nicht mehr.

Auf diese Weise erfolgt die Detektion des Signalstroms mit einer sehr begrenzten Energiemenge, die von der elektronischen Steuereinheit zu diesem Zweck verbraucht wird. Somit erlaubt dieses Vorgehen auch den Einsatz von elektrisch autarken elektronischen Steuereinheiten, sogenannten Mini-LEU's, die besonders sorgfältig mit der ihnen zur Verfügung stehenden Energiemenge umgehen müssen. Dabei wird der gesamte Vorgang der Detektion des Signalstroms nur bei einer Annäherung und Überfahrt eines Schienenfahrzeugs ausgeführt. Hierzu wird die elektronische Steuereinheit mit einem vom Kopf des Schienenfahrzeugs ausgestrahlten Tele-Powering Signal (27 MHz-Keule) aus einem Ruhezustand geweckt. Ein Teil der Energie des Tele-Powering-Signals kann dann auch neben des eigenen Energievorrats der elektronischen Steuerungseinheit für die bestimmungsgemässe Funktion der elektronischen Steuereinheit verwendet werden. Nach der Überfahrt des Schienenfahrzeug fällt die elektronische Steuereinheit wieder in den Ruhezustand.

## Patentansprüche

1. Verfahren zur Ermittlung eines von einem Stellwerk ausgegebenen Signalbegriffs, der mittels einer gleisseitig angeordneten punktförmigen Datenübertragungseinrichtung auf ein Schienenfahrzeug übertragbar ist, wobei:
a) der Signalbegriff für eine Anzahl von Signallampen ausgegeben wird und in Form von je einem Signalstrom bekannter Frequenz pro Lampenstromkreis in jedem der für die Darstellung des Signalbegriffs erforderlichen Lampenstromkreise bereitgestellt wird;
b) die punktförmige Datenübertragungseinrichtung von einer gleisseitig angeordneten elektronischen Steuerungseinheit betrieben wird; und
c) der Signalstrom in jedem der Lampenstromkreise von der elektronischen Steuereinheit mittels eines Abtastbursts mit einer Anzahl von Abtastungen abgetastet wird, wobei der zeitliche Abstand zweier aufeinanderfolgender Abtastungen innerhalb eines Abtastbursts einem vorgebbaren Bruchteil der Periodendauer des Signalstroms entspricht, wobei der Bruchteil der Periodendauer ein Viertel der Periodendauer des Signalstroms beträgt.

2. Verfahren nach Anspruch 1,
**dadurch gekennzeichnet, dass**
der Signalstrom als Wechselstrom oder als gleichgerichteter Wechselstrom ausgeführt ist.

3. Verfahren nach Anspruch 1 oder 2,
**dadurch gekennzeichnet, dass**
die punktförmige Datenübertragungseinheit eine ETCS-Transparentdaten-Balise ist.

4. Verfahren nach einem der Ansprüche 1 bis 3,
**dadurch gekennzeichnet, dass**
ein Abtastburst zwei bis fünf Abtastungen umfasst.

## Claims

1. Method for determining a signal aspect issued by a signal box, said signal aspect being transferable to a rail vehicle by means of a point data transfer device being arranged track side, wherein:
a) the signal aspect is released for a quantity of signal lamps and is provided in the form of one signal current of a known frequency for each lamp current circuit in every lamp current circuit that is required for representing the signal aspect;
b) the point data transfer device is operated by an electronic control unit being arranged track side; and
c) the signal current is sampled in each of the lamp electric circuits with a quantity of samples by the electronic control unit by means of a sample burst, wherein the time period between two consecutive samples within a sample burst equates to the predeterminable fraction of the period time of the signal current, said fraction of the period time being a quarter of the period time of the signal current.

2. Method according to claim 1,
**characterized in that**
the signal current is executed as an alternating current or as a rectified alternating current.

3. Method according to claim 1 or 2,
**characterized in that**
the point data transfer device is a ETCS transparent data balise.

4. Method according to any of the claims 1 to 3,
**characterized in that**
one sample burst comprises two to five samples.

## Revendications

1. Procédé de détermination d'un aspect de signal émis par un poste d'aiguillage, qui peut être transmis au moyen d'un dispositif de transmission de données en forme de points disposé côté voie sur un véhicule ferroviaire, dans lequel :
a) l'aspect de signal est émis pour une pluralité de lampes de signalisation et est mis à disposition sous la forme d'une fréquence connue par chaque courant de signal par circuit de lampe dans chacun des circuits de lampe nécessaires à la représentation de l'aspect de signal ;
b) le dispositif de transmission de données en forme de points est exploité par une unité de commande électronique disposée côté voie ; et
c) le courant de signal dans chacun des circuits de lampe est balayé dans chacun des circuits de lampe par l'unité de commande électronique au moyen d'un balai explorateur avec une pluralité de balayages, dans lequel l'intervalle de temps de deux balayages consécutifs au sein d'un balai explorateur correspond à une fraction pouvant être prédéfinie de la durée de période du courant de signal, dans lequel la fraction de la durée de période s'élève à un quart de la durée de période du courant de signal.

2. Procédé selon la revendication 1,
**caractérisé en ce que**
le courant de signal est réalisé en tant que courant alternatif ou en tant que courant alternatif redressé.

3. Procédé selon la revendication 1 ou 2,
**caractérisé en ce que**
l'unité de transmission de données en forme de points est une balise de données transparentes ETCS.

4. Procédé selon l'une des revendications 1 à 3,
**caractérisé en ce qu'**
un balai explorateur comprend deux à cinq balayages.
